# EUROPÄISCHE PATENTANMELDUNG

(11) **EP 1 890 332 A2**
(43) Veröffentlichungstag der Anmeldung: **20.02.2008**
(21) Anmeldenummer: 07111889.7
(22) Anmeldetag: 06.07.2007
(51) Int. Cl.: H01L 25/075, H01L 33/00

(54) **Beleuchtungsmodul und Verfahren zur Herstellung eines Beleuchtungsmoduls**

(30) Priorität: 17.08.2006 DE 102006038552
(71) Anmelder: Robert Bosch GmbH, 70442 Stuttgart (DE)
(72) Erfinder: Braun, Sigmund, 72127 Kusterdingen (DE)

(57) **Zusammenfassung**

Die Erfindung betrifft ein Beleuchtungsmodul mit wenigstens einem LED-Chip (21, 22, 101, 105, 131, 132) und wenigstens einem jeweils einem LED-Chip zugeordneten Kühlkörper (11, 12, 81, 82, 121, 122), dadurch gekennzeichnet, dass der LED-Chip auf dem ihm zugeordneten Kühlkörper (11, 12, 81, 82, 121, 122) derart angeordnet und mit dem Kühlkörper elektrisch verbunden ist, dass ein erster elektrischer Anschluss des LED-Chips (21, 22, 101, 105, 131, 132) für eine Lichterzeugung über den Kühlkörper (11, 12, 81, 82, 121, 122) erfolgt.

## Beschreibung

### Stand der Technik

Die Erfindung geht aus von einem Beleuchtungsmodul und einem Verfahren zur Herstellung eines Beleuchtungsmoduls nach Gattung der nebengeordneten Ansprüche. Aus der US 2005/0212439 A1 ist bereits ein Beleuchtungsmodul mit Leuchtdioden bekannt, bei denen die Leuchtdioden an einem Kühlkörper angeordnet sind. An der den Leuchtdioden abgewandten Seite weist der Kühlkörper stiftförmige Erweiterungen auf. Eine elektrische Kontaktierung der Leuchtdioden erfolgt über einen flexiblen Leiter, der zwischen dem Kühlkörper und den Leuchtdioden angeordnet ist und mit dem die Leuchtdioden jeweils elektrisch leitend verbunden sind.

### Offenbarung der Erfindung

### Vorteile der Erfindung

Das erfindungsgemäße Beleuchtungsmodul mit den Merkmalen des Anspruchs 1 hat demgegenüber den Vorteil, dass durch die elektrische Kontaktierung eines Anschlusses eines LED-Chips, der auf einen Kühlkörper aufgebracht wird, eine elektrische Kontaktierung des LED-Chips auf einfache Weise erfolgen kann. Hierdurch kann auf andere Kontaktierungsmittel, wie z. B. eine Leiterbahnkontaktierung, verzichtet werden. Zudem ist in vorteilhafter Weise unmittelbar auch eine Kühlung des LED-Chips möglich. Ferner kann eine Beeinflussung des Potentials durch den Kühlkörper selbst vermieden werden, da das elektrische Potential unmittelbar über den Kühlkörper zu dem LED-Chip geführt wird.

Eine besonders vorteilhafte Herstellung eines erfindungsgemäßen Beleuchtungsmoduls ist in dem nebengeordneten Verfahrensanspruch angegeben. Besonders vorteilhaft ist es, eine Positionierung des Kühlkörpers in dem Beleuchtungsmodul durch eine Anordnung des Kühlkörpers an einem Träger vorzusehen. Hierdurch lassen sich der Träger und der auf dem Träger angeordnete LED-Chip in geeigneter Weise in dem Beleuchtungsmodul so positionieren, dass das von dem LED-Chip erzeugte Licht in eine gewünschte Richtung abgegeben wird.

Durch die in den abhängigen Ansprüchen aufgeführten Maßnahmen sind vorteilhafte Weiterbildungen und Verbesserungen des in den unabhängigen Ansprüchen angegebenen Beleuchtungsmoduls und des Verfahrens zur Herstellung des Beleuchtungsmoduls möglich. Besonders vorteilhaft ist, den LED-Chip auf den Kühlkörper aufzulöten. Hierdurch ist eine besonders gut leitende und haltbare Kontaktierung des LED-Chips auf dem Kühlkörper möglich.

Ferner ist es vorteilhaft, den Kühlkörper stiftförmig auszubilden und hierbei bevorzugt auch Rippen in den Kühlkörper einzubringen. Hierdurch kann die Wärmeabstrahlung des Kühlkörpers verbessert werden.

Weiterhin ist es vorteilhaft, eine elektronische Ansteuereinheit auf einer dem LED-Chip abgewandten Seite des Kühlkörpers anzuordnen. Einerseits entsteht bei einem Betrieb eine geringe Wärmebelastung für die Ansteuereinheit. Andererseits kann beispielsweise durch einen Träger des Kühlkörpers und durch die elektronische Ansteuereinheit ein Kanal gebildet werden, in dem die Kühlkörper mit Luft umströmt und somit besonders gut gekühlt werden können.

Ferner ist es vorteilhaft, einen zweiten elektrischen Anschluss des LED-Chips an dem LED-Chip selbst anzuordnen und zur Realisierung einer Reihenschaltung an einen benachbart an dem Beleuchtungsmodul angeordneten Kühlkörper zu führen. Somit ist eine Reihenschaltung möglich, bei der jeweils keine Leiterbahn erforderlich ist und zusätzlich zu der elektrischen Kontaktierung über den Kühlkörper ein zweiter elektrischer Anschlusskontakt, beispielsweise in Form eines angebondeten Drahtes, nur an einer Stelle an dem LED-Chip angeordnet werden muss.

Besonders vorteilhaft lässt sich ein Träger zum Halten einer Vielzahl von Kühlkörpern durch einen Kunststoffträger realisieren, da der Kunststoffträger einerseits beispielsweise in einem Spitzgussverfahren leicht gefertigt werden kann, wobei beispielsweise der oder die Kühlkörper bei dem Spritzgießen in den Kunststoffträger eingebracht werden. Andererseits ist der Kunststoffkörper vorzugsweise isolierend ausgeführt, so dass die einzelnen Kühlkörper zueinander auf einfache Weise elektrisch isoliert werden.

Es ist ferner vorteilhaft, die Kühlkörper auf einen Träger aufzukleben. Hierdurch ist eine flexible Anordnung der Lichtquellen auf dem Träger möglich. Zudem kann ein Klebeprozess im Gegensatz einer Umspritzung, auch getrennt von der Herstellung eines Trägers des Beleuchtungsmoduls erfolgen.

Ferner ist es vorteilhaft, an dem Träger Mittel zur Farbkonversion des von dem LED-Chips erzeugten Lichts anzuordnen. Durch eine teilweise Frequenzkonversion von beispielsweise von einem LED-Chip erzeugtem blauem Licht zu längerwelligem Licht kann somit beispielsweise Weißlicht erzeugt werden.

Ferner ist es vorteilhaft, zur Erleichterung einer Anordnung des LED-Chips auf den Kühlkörper an dem Kühlkörper ein Kupferelement anzubringen. Eine Lötverbindung, aber auch eine Wärmeleitung zu dem Kühlkörper wird durch ein zusätzliches Kupferelement gegebenenfalls verbessert.

Ferner ist der Kühlkörper bevorzugt derart ausgeformt, dass er einen Reflektor für den seitlich emmitierenden Lichtanteil des LED-Chips bildet. Hierdurch kann auf die Anordnung eines zusätzlichen Reflektorelements verzichtet werden.

Weiterhin ist es vorteilhaft, dass der Kühlkörper auf der dem LED-Chip abgewandten Seite einen Befestigungs- bzw. Kontaktierungsanschluss aufweist. Somit ist es möglich, den Kühlkörper einerseits beispielsweise durch ein Anordnen an einer Leiterplatte oder an einem Trageelement auf der dem LED-Chip abwandten Seite in dem Beleuchtungsmodul zu fixieren. Andererseits ist es möglich, den Kühlkörper somit auf einfache Weise mit einem elektrischen Potential zur Speisung eines Stromes durch die an dem Kühlkörper angeordnete Lichtquelle zu verbinden.

Weiterhin ist es vorteilhaft, an dem Kühlkörper eine Heat-Pipe zur beschleunigten Wärmeabfuhr vorzusehen.

Es ist ferner vorteilhaft, auf den Kühlkörper ein optisches Element zur Lenkung des von dem LED-Chip erzeugten Lichts aufzusetzen, so dass das Licht in eine vorgegebene Richtung gebündelt oder aufgeweitet werden kann.

### Kurze Beschreibung der Zeichnungen

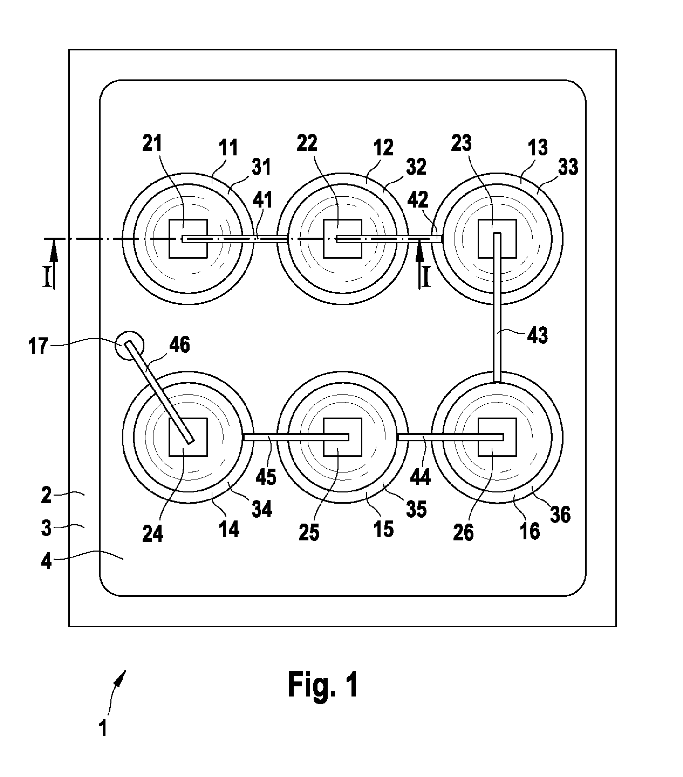

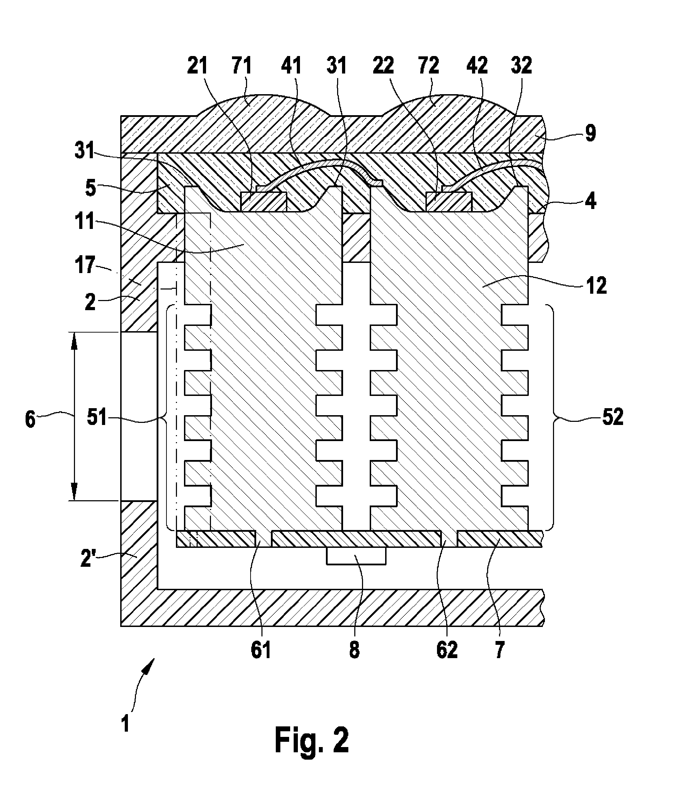

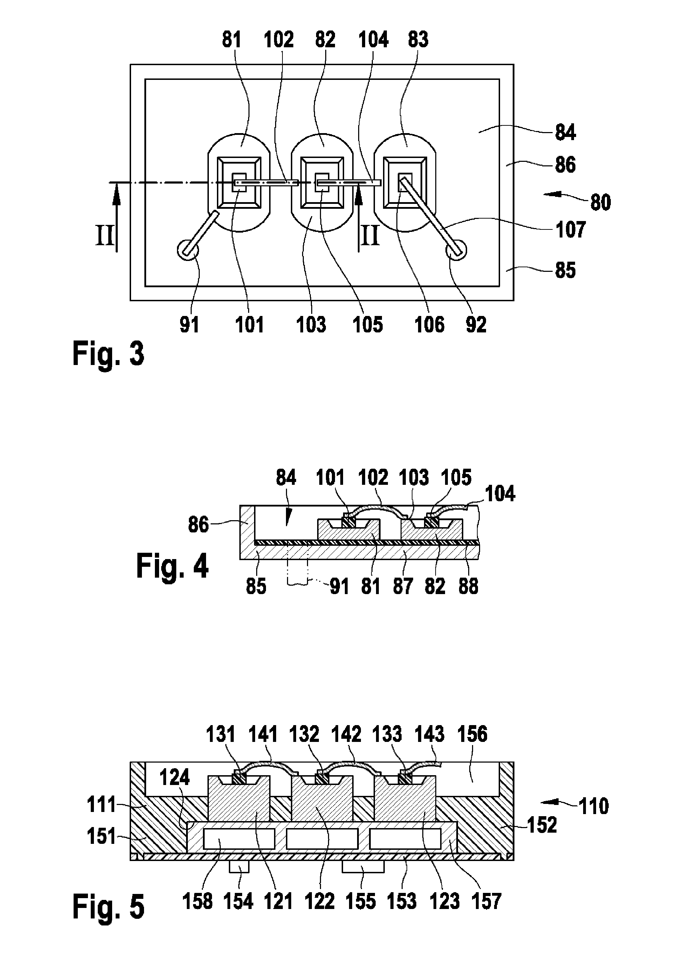

Ausführungsbeispiele der Erfindung sind in der Zeichnung dargestellt und in der nachfolgenden Beschreibung näher erläutert. Es zeigen Figur 1 eine Aufsicht auf ein erstes Ausführungsbeispiel eines erfindungsgemäßen Beleuchtungsmoduls, Figur 2 einen Schnitt durch das erfindungsgemäße Beleuchtungsmodul gemäß Figur 1, Figur 3 ein zweites Ausführungsbeispiel eines erfindungsgemäßen Beleuchtungsmoduls in einer Aufsicht, Figur 4 einen Schnitt durch das zweite Ausführungsbeispiel des erfindungsgemäßen Beleuchtungsmoduls gemäß Figur 3, Figur 5 ein drittes Ausführungsbeispiel eines erfindungsgemäßen Beleuchtungsmoduls.

Ausführungsformen der Erfindung

Das erfindungsgemäße Beleuchtungsmodul kann für beliebige Beleuchtungszwecke verwendet werden. Insbesondere ist einer Verwendung für eine Beleuchtung vorteilhaft, bei der dauerhaft eine hohe Lichtstärke abgegeben werden muss und bei der sich die verwendeten LED-Chips erwärmen können. Unter einem LED-Chip in der beschriebenen Ausführungsform soll ein Halbleiterelement als solches verstanden werden, das bei einer an das Halbleiterelement angelegten elektrischen Spannung Licht abgibt und das selbst keine besonderen elektrischen Anschlusselemente, wie Kontaktdrähte oder Lötzungen, oder ein Gehäuse aufweist. Ein entsprechender LED-Chip kann bei der im Folgenden beschriebenen Ausführungsform unverpackt und ohne weitere Bearbeitung in dem Beleuchtungsmodul verbaut werden.

In der Figur 1 ist ein erstes Ausführungsbeispiel für ein Beleuchtungsmodul 1 dargestellt. Das Beleuchtungsmodul 1 weist einen Träger 2 auf, der aus einem Isolator gebildet ist, vorzugsweise einem Kunststoffmaterial. Der Träger 2 weist einen Rand 3 auf, der eine Fläche der einer Wanne 4 einschließt. In dem Bereich der Bodenfläche der Wanne 4 sind sechs Kühlkörper 11, 12, 13, 14, 15, 16 in den Träger 2 eingelassen, die jeweils einen ihnen zugeordneten LED-Chip 21, 22, 23, 24, 25, 26 tragen. In einer ersten Ausführungsform sind in den Träger 2 entsprechende Bohrungen für die Kühlkörper eingelassen. In einer anderen Ausführungsform können die Kühlkörper aber auch während eines Spritzgussschrittes von einem Kunststoffmaterial umgeben sein, so dass die Kühlkörper nach einem Aushärten von dem Träger 2 gehalten werden.

Die Kühlkörper weisen jeweils einen Rand 31, 32, 33, 34, 35, 36 auf. Die Kühlkörper sind aus einem thermisch gut leitfähigen Metall, beispielsweise aus Kupfer gefertigt. So können die Kühlkörper z.B. aus einem Kupferstück gedreht bzw. gefräst werden.

Der LED-Chip ist in geeigneter Weise an einer Seite mit dem Kühlkörper elektrisch leitend verbunden. Beispielsweise kann der LED-Chip hierzu auf den Kühlkörper mit einem Leitkleber aufgeklebt werden, so dass über den Leitkleber eine elektrische Verbindung zwischen dem Kühlkörper und dem ihm zugeordneten LED-Chip hergestellt wird. In einer weiteren Ausführungsform kann der LED-Chip aber auch jeweils auf den Kühlkörper aufgelötet werden. In einer bevorzugten Ausführungsform ist hierzu ein Kupfer-Element zwischen dem LED-Chip und dem Kühlkörper angeordnet, das jedoch in der Figur 1 nicht gezeigt ist. Der erste Kühlkörper 11 ist auf seiner dem LED-Chip 21 abgewandten Seite elektrisch kontaktiert. Die angelegte Spannung wird über den Kühlkörper 11 zu der Rückseite des LED-Chips 21 geleitet. An der Vorderseite des LED-Chips ist eine elektrische Verbindung 41 aufgebondet, die von der Vorderseite des LED-Chips 21 zu dem Rand 32 des zweiten Kühlkörpers 12 führt. Entsprechend ist die Vorderseite des zweiten LED-Chips 22 wieder mit dem Rand 33 des dritten Kühlkörpers 13 über eine zweite elektrische Verbindung 42 verbunden. Eine dritte elektrische Verbindung 43 verbindet den dritten LED-Chip 23 mit dem Rand 36 des vierten Kühlkörpers 16. Eine vierte elektrische Verbindung 44 verbindet den vierten LED-Chip 26 mit dem Rand 35 des fünften Kühlkörpers 15. Von dem fünften LED-Chip 25 führt eine fünfte elektrische Verbindung 45 zu dem Rand 34 des sechsten Kühlkörpers 14. Von dem sechsten LED-Chip 24 führt eine sechste elektrische Verbindung 46 zu einem weiteren elektrischen Anschluss 17, der in die Wanne 4 eingelassen ist. Durch die sechs elektrischen Verbindungen ist damit eine Reihenschaltung der sechs LED-Chips erreicht, indem eine Spannung zwischen dem ersten Kühlkörper 11 und dem elektrischen Anschluss 17 an die Reihenschaltung der LED-Chips angelegt wird. Die angelegte Spannung wird dabei so gewählt, dass zwischen der ersten Seite des Halbleitermaterials jedes LED-Chips, die den Kühlkörper kontaktiert, und der zweiten Seite des Halbleitermaterials jedes LED-Chips, die mit einem Bonddraht verbunden ist, eine für eine Lichterzeugung durch das Halbleitermaterial zumindest notwendige Spannung abfällt. Somit erzeugen die einzelnen LED-Chips bei einem Anlegen der erforderlichen Betriebsspannung ihrer Materialeigenschaft entsprechendes Licht.

Anstelle der hier beispielhaft gezeigten Konfiguration mit sechs LED-Chips und jeweils zugeordneten Kühlkörpern können auch mehr oder weniger Kühlkörper mit LED-Chips an dem Träger 2 zur Ausbildung eines erfindungsgemäßen Beleuchtungsmoduls angeordnet werden. So ist z.B. auch eine Konfiguration mit nur einem LED-Chip und einem zugeordneten Kühlkörper möglich.

In der Figur 2 ist das Beleuchtungsmodul 1 der Figur 1 in einer Seitenansicht gemäß der strichpunktierten Linie I in der Figur 1 in einer Schnittdarstellung gezeigt. Die Kühlkörper 11, 12 sind stabförmig, vorzugsweise zylinderförmig ausgebildet. Sie durchstoßen den Träger 2 in für sie vorgesehene Öffnungen und erstrecken sich auf der dem LED-Chip 21, 22 jeweils abweisenden Seite des Trägers 2. Hierbei bilden die Kühlkörper 11, 12 jeweils Kühlrippen 51, 52 auf. In dem vorliegenden Ausführungsbeispiel sind hierzu umlaufende Einkerbungen in die Kühlkörper 11, 12 jeweils konzentrisch um den zylinderförmigen Kühlkörper herum eingebracht. Der Träger 2 bildet ein Gehäuse mit einem Rückdeckel 2' aus, das eine Öffnung 6 aufweist, so dass die Bereiche der Kühlkörper 11, 12 mit den Kühlrippen 51, 52 von Luft umströmt werden können, so dass die Kühlkörper 11, 12 Wärme an den Luftstrom abgeben können.

An dem den LED-Chips 21, 22 jeweils abweisenden Enden der Kühlkörper 11, 12 sind stiftförmige Erweiterungen 61, 62 angeordnet, mit denen die Kühlkörper 11, 12 vorzugsweise über eine Lötverbindung an einer Leiterplatte 7 angeordnet sind. Vorzugsweise erfolgt nur bei dem ersten Kühlkörper 11 eine elektrische Kontaktierung, da der zweite Kühlkörper 12 über die Bondverbindung über seinen Rand 32 mit dem ersten LED-Chip 21 kontaktiert wird. Bei einer Parallelschaltung mehrerer LED-Chips an einem Träger können aber auch mehrere Kühlkörper elektrisch mit einer Leiterplatte 7 kontaktiert werden. Ferner kann der erste Kühlkörper in einer anderen Ausführungsform aber auch unmittelbar über seinen Rand 31 kontaktiert werden.

Bevorzugt sind auf der den Kühlkörpern 11, 12 abgewandten Seite der Leiterplatte 7 elektronische Bauteile 8 angeordnet, über die eine Ansteuerung der LED-Chips 21, 22 erfolgt. Ein elektronischer Anschluss, insbesondere ein Steckeranschluss zum Anschließen des Beleuchtungsmoduls, ist vorzugsweise auf der Leiterplatte 7 angeordnet, jedoch in der Figur 2 nicht dargestellt. Strichzweipunktiert ist in der Figur 2 der elektrische Anschluss 17 dargestellt, der eine Kontakfläche in der Wanne 4 bildet und beispielsweise als ein Drahtstift von der Wanne 4 zu der Leiterplatte 7 führt und hier elektrisch kontaktiert wird.

Die durch den Träger 2 ausgebildete Wanne 4 wird in dem hier gezeigten Ausführungsbeispiel über ein transparentes optisches Element 9 abgedeckt. Das transparente optische Element 9 ist bevorzugt aus einem transparenten Kunststoffmaterial ausgebildet und weist bevorzugt in einem Bereich der LED-Chips derartige Erweiterungen 71, 72 auf, dass vor den LED-Chips jeweils eine Linsenstruktur entsteht. Somit kann das Licht der LED-Chips einerseits gebündelt und andererseits hinsichtlich einer Lichtabstrahlung des Beleuchtungselements homogenisiert werden.

Ein Zwischenraum 5 zwischen den Kühlkörpern 11, 12, den LED-Chips 21, 22 und dem optischen Element 9 wird bevorzugt mit einem Silikonmaterial ausgegossen. Hierdurch werden insbesondere die elektrischen Verbindungen geschützt, nämlich die Bonddrähte zwischen den LED-Chips und den Rändern der Kühlkörper. Ferner werden auch die LED-Chips selbst geschützt. Zudem wird durch eine Silikonfüllung die Wasserdichtigkeit des Moduls gewährleistet. Ferner ist eine optische, luftfreie Verbindung zwischen dem LED-Chip und dem aufgelegten optischen Element 9 möglich. In einer bevorzugten Ausführungsform weist das Silikonmaterial derartige Bestandteile auf, die eingestrahltes Licht teilweise in anderer Frequenz wieder abgeben. Somit ist es möglich, die Frequenz des von dem Beleuchtungsmodul ausgestrahlten Lichts zu beeinflussen. So ist es beispielsweise möglich, dass bei von den LED-Chips erzeugtem, blauem Licht ein Material hinzugefügt wird, durch das ein Teil des blauen Lichtes in rotes bzw. grünes Licht umgewandelt wird. Somit ist es beispielsweise möglich, weißes Licht mit LED-Chips zu erzeugen, die nur blaues Licht abgeben.

Die Kühlkörper 11, 12 bilden an ihren den LED-Chips jeweils zuweisenden Enden eine wannenförmige Struktur aus, in der die LED-Chips 21, 22 angeordnet sind. Damit ist die Oberfläche des Kühlkörpers eine Reflexionsfläche für den seitlich emmitierende Lichtanteil des von den LED-Chips erzeugten Lichts. Zur Steigerung der Reflexion kann der Kühlkörper zumindest in diesem Bereich mit einer Licht reflektierenden Schicht, beispielsweise mit weißer Farbe, beschichtet sein.

Eine Herstellung des Beleuchtungsmoduls gemäß der Figuren 1, 2 erfolgt derart, dass zunächst die Kühlkörper 11, 12 gedreht werden und beispielsweise in einem Spritzgussverfahren in dem Träger 2 eingebracht werden, wobei Träger 2 zugleich hergestellt wird. Anschließend werden die LED-Chips auf die Kühlkörper beispielsweise aufgelötet. Danach werden die elektrischen Kontaktierung der LED-Chips untereinander durch Bonden hergestellt. Im Anschluss wird das Füllmaterial in den Zwischenraum 5 eingefüllt und der Zwischenraum 5 durch ein Auflegen oder insbesondere auch durch ein Aufclipsen des optischen Elements 9 auf den Träger 2 abgeschlossen. Im Anschluss wird noch die Leiterplatte 7 an der Rückseite der Kühlkörper 11, 12 aufgebracht. Das Beleuchtungsmodul wird durch Schließen der Rückseite mittels des Rückdeckels 2'abgeschlossen. Anschließend kann das Beleuchtungsmodul über eine Steckerverbindung mit der Spannungszuführung zur Spannungsversorgung zur Lichterzeugung verbunden werden.

Mehrere Beleuchtungsmodule können nebeneinander angeordnet und über entsprechende Stecker, insbesondere flexible Leitverbindungen, miteinander verbunden werden.

Ein zweites Ausführungsbeispiel ist in der Figur 3 dargestellt. Ein Beleuchtungsmodul 80 weist einen ersten Kühlkörper 81, einen zweiten Kühlkörper 82 und einen dritten Kühlkörper 83 auf. Die Kühlkörper 81, 82, 83 sind in einer Wanne 84 eines Trägers 85 angeordnet, wobei der Träger 85 vorzugsweise einen Rand 86 zur Aufnahme eines Füllmaterials, wie beispielsweise ein Silikongel, aufweist. Die Figur 4 stellt eine Seitenansicht einer Schnittdarstellung entlang der strichpunktierten Linie II in der Figur 3 dar. Die LED-Chips 81, 82 sind auf einem Boden 87 der Wanne 84 mittels eines Klebebandes 88 aufgeklebt. Eine elektrische Verbindung erfolgt ausgehend von einem ersten elektrischen Kontakt 91, der vorzugsweise den Boden 87 durchstößt, zu einem Rand des ersten Kühlkörpers 81, auf dem ein erster LED-Chip 101 angeordnet ist, der mit einer Seite in einem elektrischen Kontakt zu dem ersten Kühlkörper 81 steht. Über eine elektrische Bondverbindung 102 wird ein elektrischer Kontakt zwischen dem ersten LED-Chip 101 und dem Rand 103 des zweiten Kühlkörpers 82 hergestellt. In entsprechender Weise erfolgt eine zweite elektrische Verbindung 104 von dem zweiten LED-Chip 105 zu dem dritten Kühlkörper 83. Von dem dritten LED-Chip 106 erfolgt eine dritte elektrische Verbindung 107 zu einem zweiten elektrischen Anschluss 92. Eine elektrische Spannung wird nun zwischen den beiden elektrischen Anschlüssen 91 und 92 angelegt. In der Figur 4 ist der erste elektrische Anschluss 91 strichzweipunktiert dargestellt. An jedem LED-Chip fällt nun zwischen dem Anschluss auf der Rückseite, an der der LED-Chip mit dem Kühlkörper verbunden ist, und dem Bonddraht, der jeweils an der Vorderseite des LED-Chips angeschlossen ist, die entsprechende Teilspannung entsprechend des Anteils des LED-Chips an der do gebildeten Reihenschaltung ab.

Eine Herstellung des in den Figuren 3, 4 gezeigten Beleuchtungsmoduls kann dabei derart erfolgen, dass die Kühlkörper beispielsweise in einem Fließpressverfahren hergestellt werden. Insbesondere ist darauf zu achten, dass die Rückseite sehr eben ausgeführt ist. Der Träger 85 wird bevorzugt aus Metall, das gut wärmeleitend ist, ausgebildet. Auf dem Boden 87 der Wanne 84 des Trägers wird eine Klebefolie 88 aufgelegt, die vorzugsweise doppelseitig klebt und die elektrisch isolierend ist. Besonders vorteilhaft sind ferner eine gute Wärmeleitfähigkeit sowie eine möglichst gleichmäßige Dicke der Klebefolie. Anschließend werden die Kühlkörper auf die Klebefolie aufgesetzt. Für die elektrischen Anschlüsse 91, 92 sind beispielsweise Bohrungen zur Anbringung der elektrischen Anschlüsse eingebracht. In einer weiteren Ausführungsform können die Anschlüsse aber auch ebenfalls aufgeklebt und von der Vorderseite jeweils kontaktiert werden. Durch die elektrische Isolierung der Kühlkörper mittels der Klebeschicht ist eine Ausbildung des Trägers auch aus Metall möglich. In einer weiteren Ausführungsform ist es jedoch auch möglich, den Träger aus Kunststoff auszubilden, sofern eine zulässige thermische Belastung im vorgesehenen Betrieb nicht überschritten wird. Anschließend kann die Wanne 84 mit einem Silikonmaterial vergossen werden.

In der Figur 5 ist ein drittes Ausführungsbeispiel eines erfindungsgemäßen Beleuchtungsmoduls 110 gezeigt, das in einer seitlichen Schnittdarstellung gezeigt ist. In einen Träger 111 sind drei Kühlkörper 121, 122 und 123 eingelassen. Die Kühlkörper 121, 122 und 123 durchstoßen zwar den Träger 111, gehen aber nicht über dessen Rückseite 124 hinaus. Die Rückseite 124 ist hierbei den LED-Chips 131, 132 und 133 abgewandt. Die LED-Chips 131, 132, 133 sind, wie in den übrigen Ausführungsbeispielen bereits erläutert, über elektrische Verbindungen, vorzugsweise Bondverbindungen 141, 142, 143 elektrisch auf der einen Seite kontaktiert, während sie auf der anderen Seite elektrisch mit dem Kühlkörper verbunden sind. An den Träger 111 sind Halteelemente 151, 152 angeformt, die eine elektronische Leiterplatte 153 tragen. Auf der Leiterplatte 153 sind elektronische Bauteile 154, 155 angeordnet, die zur Ansteuerung der LED-Chips 131, 132, 133 dienen. Der Träger 111 bildet eine Wanne 156 aus, in der die LED-Chips 131, 132, 133 angeordnet sind. Diese Wanne 156 kann mit einem Silikonmaterial vergossen werden. In dem Zwischenraum zwischen den Kühlkörpern 121, 122, 123 und der Leiterplatte 153 ist eine Heat-Pipe 157 angeordnet, die vorzugsweise aus einem gut wärmeleitfähigen Material gebildet ist und die einen Luftstrom durch ihr Inneres zulässt und damit mittels Wärmekonfektion eine Wärmeabfuhr von dem Kühlkörper 121, 122, 123 ermöglicht. Ferner ist es aber auch möglich, zur Verbesserung der Wärmeleitung eine Flüssigkeit im Inneren Der Heat-Pipe 157 zirkulieren zu lassen. Die Heat-Pipe 157 wird vorzugsweise durch ein Strangpressverfahren hergestellt. Dadurch lässt sich günstig ein Profil mit innenliegenden Kanälen ausführen. In einer alternativen Ausführungsform kann das Beleuchtungsmodul 110 auch ohne eine Heat-Pipe ausgebildet werden.

Zur Herstellung des Beleuchtungsmoduls werden zunächst die Kühlkörper 121, 122, 123 in einem Drehverfahren oder einem Fließpressverfahren hergestellt. Zur Erzeugung eines Reflektors weisen sie eine konkave Reflexionsgeometrie auf der dem LED-Chip jeweils zuweisenden Seite auf. Eine hochglänzende Oberfläche zur Verbesserung des Reflexionsverhaltens wird beispielsweise durch eine galvanische Beschichtung erzeugt. Anschließend werden die Kühlkörper mit dem Kunststoffmaterial des Trägers 2 umspritzt. Um eine gute Wärmeleitung zu ermöglichen, wird die Rückseite 124 plan überschliffen. Um eine elektrische Isolierung zur Heat-Pipe 157 herzustellen, wird ein isolierendes, vorzugsweise doppelseitiges Klebeband auf die Rückseite 124 aufgebracht. Anschließend werden die LED-Chips 131, 132, 133 auf den Kühlkörpern 121, 122, 123 verlötet und die elektrischen Verbindungen werden mittels Bonden hergestellt. Anschließend wird die Wanne 156 mit einem Silikongel aufgefüllt und gegebenenfalls wird ein in der Figur 5 nicht gezeigtes optisches Element aufgeclipst. Im Anschluss wird die Heat-Pipe 157 auf das auf der Rückseite 124 angeordnete Klebeband aufgeklebt. Zum Schutz während der Fertigung kann auf dem Klebeband zunächst eine Schutzfolie aufgebracht werden, die vor der Anordnung der Heat-Pipe entfernt wird. Die Heat-Pipe 157 ist dabei bevorzugt so ausgeführt, dass die Konvektionsöffnungen 158 in einem fertig montierten Beleuchtungsmodul in Richtung des Schwerefelds der Erde derart ausgerichtet sind, dass durch thermische Konvektion Luft durch die Heat-Pipe geführt wird. Anschließend wird die Leiterplatte 153 auf die Halteelemente 151, 152 beispielsweise mittels Schneid-Klemmtechnik aufgepresst.

## Patentansprüche

1. Beleuchtungsmodul mit wenigstens einem LED-Chip (21, 22, 101, 105, 131, 132) und wenigstens einem jeweils einem LED-Chip zugeordneten Kühlkörper (11, 12, 81, 82, 121, 122), **dadurch gekennzeichnet, dass** der LED-Chip auf dem ihm zugeordneten Kühlkörper (11, 12, 81, 82, 121, 122) derart angeordnet und mit dem Kühlkörper elektrisch verbunden ist, dass ein erster elektrischer Anschluss des LED-Chips (21, 22, 101, 105, 131, 132) für eine Lichterzeugung über den Kühlkörper (11, 12, 81, 82, 121, 122) erfolgt.

2. Beleuchtungsmodul nach Anspruch 1, **dadurch gekennzeichnet, dass** der LED-Chip (21, 22, 101, 105, 131, 132) auf den Kühlkörper (11, 12, 81, 82, 121, 122) gelötet ist.

3. Beleuchtungsmodul nach einem der vorhergehenden Ansprüche, **dadurch gekennzeichnet, dass** der Kühlkörper (11, 12) stiftförmig ist.

4. Beleuchtungsmodul nach Anspruch 3, **dadurch gekennzeichnet, dass** der Kühlkörper (11, 12) Kühlrippen (51, 52) aufweist.

5. Beleuchtungsmodul nach einem der vorhergehenden Ansprüche, **dadurch gekennzeichnet, dass** eine elektronische Ansteuereinheit (7, 8, 153, 154, 155) auf einer dem LED-Chip (21, 22, 101, 105, 131, 132) abgewandten Seite des Kühlkörpers (11, 12, 81, 82, 121, 122) angeordnet ist.

6. Beleuchtungsmodul nach einem der vorhergehenden Ansprüche, **dadurch gekennzeichnet, dass** ein zweiter elektrischer Anschluss (41, 42, 102, 104, 141, 142) des LED-Chips (21, 22, 101, 105, 131, 132) von dem LED-Chip zu einem Kühlkörper eines weiteren LED-Chips des Beleuchtungsmoduls (1, 80, 110) zur Realisierung einer Reihenschaltung geführt ist.

7. Beleuchtungsmodul nach einem der vorhergehenden Ansprüche, **gekennzeichnet durch** einen Träger (2, 85, 111) zum Halten einer Vielzahl von Kühlkörpern.

8. Beleuchtungsmodul nach Anspruch 7, **dadurch gekennzeichnet, dass** an dem Träger (2, 8, 111) Mittel zur Farbkonversion des von den LED-Chips erzeugten Lichts angeordnet sind.

9. Beleuchtungsmodul nach einem der vorhergehenden Ansprüche, **dadurch gekennzeichnet, dass** der Kühlkörper (11, 12, 81, 82, 121, 122) derart ausgebildet ist, dass er einen Reflektor für das von dem LED-Chip erzeugte Licht bildet.

10. Beleuchtungsmodul nach einem der vorhergehenden Ansprüche, **dadurch gekennzeichnet, dass** der Kühlkörper (11, 12) auf der dem LED-Chip abgewandten Seite einen Befestigungsanschluss (62) und/oder einen elektrischen Kontaktierungsanschluss (61) aufweist.

11. Beleuchtungsmodul nach einem der vorhergehenden Ansprüche, **dadurch gekennzeichnet, dass** der Kühlkörper (111) mit einer Heat-Pipe (157) verbunden ist.

12. Verfahren zur Herstellung eines Beleuchtungsmoduls nach einem der vorhergehenden Ansprüche, wobei wenigstens ein Kühlkörper an einem Träger angeordnet wird, wobei auf dem Kühlkörper ein LED-Chip aufgebracht wird und wobei eine elektrische Kontaktierung zwischen dem Kühlkörper und dem LED-Chip hergestellt wird.

13. Verfahren nach Anspruch 12, **dadurch gekennzeichnet, dass** der Kühlkörper zur Herstellung des Trägers und zur Anordnung an dem Träger mit einem Kunststoffmaterial umspritzt wird.

14. Verfahren nach Anspruch 12, **dadurch gekennzeichnet, dass** der Kühlkörper auf den Träger aufgeklebt wird.

15. Verfahren nach einem der Ansprüche 12-14, **dadurch gekennzeichnet, dass** in eine aus dem Träger gebildete Wanne ein Material zur Farbkonversion des von dem LED-Chips erzeugten Lichts gegeben wird.

16. Verfahren nach einem der Ansprüche 12-15, **dadurch gekennzeichnet, dass** auf den Träger ein optisches Element zur Lenkung des von dem LED-Chips erzeugten Lichts aufgesetzt wird.
